(19) Europäisches Patentamt
European Patent Office
Office européen des brevets

(11) **EP 1 178 355 A2**

(12) **EUROPÄISCHE PATENTANMELDUNG**

(43) Veröffentlichungstag:
06.02.2002 Patentblatt 2002/06

(51) Int Cl.$^7$: **G03F 7/20**

(21) Anmeldenummer: 01116218.7

(22) Anmeldetag: 04.07.2001

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: 31.07.2000 DE 10037243

(71) Anmelder: **Infineon Technologies AG**
**81669 München (DE)**

(72) Erfinder:
• **Luhn, Gerhard**
**01445 Radebeul (DE)**
• **Sarlette, Daniel**
**01445 Radebeul (DE)**

(74) Vertreter: **Graf Lambsdorff, Matthias, Dr. et al**
**Patentanwälte Lambsdorff & Lange Dingolfinger Strasse 6**
**81673 München (DE)**

(54) **Regelsystem für photolithographische Prozesse**

(57) Bei einem erfindungsgemäßen Regelungsverfahren photolithographischer Prozesse werden aus den an prozessierten Halbleiterscheiben gemessenen Linienbreitenfehlern und/oder Lagefehlern Korrekturwerte für die Belichtungsstärke und/oder die xy-Positionierung der Halbleiterscheibe berechnet und optimierte Korrekturwerte für ein nachfolgend zu prozessierendes Los von Halbleiterscheiben werden berechnet, indem über eine Anzahl zurückliegend berechneter Korrekturwerte gemittelt wird, wobei nur solche Korrekturwerte herangezogen werden, die innerhalb eines vorbestimmten Wertbereichs liegen.

Fig. 2

**Beschreibung**

Die Erfindung betrifft ein Regelsystem für photolithographische Prozesse an mit Photoresist beschichteten Halbleiterscheiben und ein Verfahren zur Regelung derartiger photolithographischer Prozesse unter Verwendung eines derartigen Regelsystems. Ein erfindungsgemäßes Regelsystem beinhaltet eine Regelschleife, mit der in einem automatisierten Verfahren bestimmte Prozeßparameter durch Vermessung und Auswertung der Resiststrukturen bereits prozessierter Halbleiterscheiben modifiziert und für die Prozeßführung der anschließend zu prozessierenden Halbleiterscheiben eingesetzt werden.

Bei der Herstellung integrierter mikroelektronischer Halbleiterschaltkreise wird in der Regel in mindestens einem Verfahrensschritt eine Schicht aus einem Photoresist auf die Oberfläche einer Halbleiterscheibe aufgebracht und mittels photolithographischer Prozesse strukturiert. Die Strukturierung erfolgt durch lichtoptische Projektion einer Maskenstruktur auf die Resistschicht und anschließende Entwicklung der Resistschicht. Für die lichtoptische Abbildung wird ein sogenannter Waferstepper oder Photostepper verwendet, der eine UV-Lichtquelle, ein Maskenretikel, eine lichtoptische Abbildungsvorrichtung und einen Auflagetisch für eine Halbleiterscheibe aufweist. Bei lichtoptischen Abbildungsverfahren wird zumeist eine 5:1-Verkleinerung der Maske auf die Resistschicht vorgenommen. Bei der Röntgenlithographie wird hingegen im sogenannten Proximity-Verfahren ein lichtoptischer Schattenwurf der in einem geringen Abstand oberhalb der Resistschicht befindlichen Maske auf die Resistschicht erzeugt.

Bereits in den achtziger Jahren stellten die Forderungen an die Genauigkeit der Belichtungsprozesse ein Problem dar, welches mit den Toleranzen der Anlagen nicht mehr zu bewältigen war. Für die Optimierung des Belichtungsprozesses bieten die als Belichtungsmaschinen verwendeten Photostepper die Möglichkeit an, die Belichtungsstärke oder -dosis, die Fokussierung und die Positionierung der Halbleiterscheibe auf dem Auflagetisch kontinuierlich rechnergesteuert oder manuell zu verändern. Bei einer rechnergesteuerten Änderung können durch eine Bedienperson auf einer Eingabeeinheit Korrekturwerte (Offset-Werte) für die Beleuchtungsstärke, die Fokussierung oder die xy-Positionierung der Halbleiterscheibe auf dem Auflagetisch eingegeben werden. Wenn ein erneuter Belichtungsprozeß gestartet wird, so wird dieser durch den Waferstepper mit den neuen Korrekturwerten ausgeführt.

Mit diesen Einstellmöglichkeiten eröffnen sich nun zwei Varianten, mit denen trotz höherer Anforderungen noch mit den vorhandenen Maschinen gearbeitet werden kann.

Bei der ersten, als Vorläufer-Prinzip bezeichneten Variante wird zuerst eine Scheibe aus einem Los (Gruppe von oder vorgegebene Anzahl von zu prozessierenden Halbleiterscheiben) entnommen, mit einer Photoresistschicht versehen, in einem Photostepper unter Verwendung einer Maske mit definierten Strukturen mit Standardparametern belichtet und anschließend entwickelt. Dann wird die strukturierte Photoresistschicht auf Lagefehler (OV, overlay) und Linienbreitenfehler (CD, critical dimension) der erzeugten Photoresiststrukturen durch ein Rasterelektronenmikroskop oder ein optisches Mikroskop vermessen und die gemessenen Abweichungen dokumentiert. Anhand dieser Meßergebnisse werden die optimalen Einstellwerte für die Belichtungsstärke, die Fokussierung und die xy-Positionierung der Halbleiterscheiben des gesamten Loses ermittelt. Der Photoresist auf der Vorläuferscheibe wird entfernt und danach wird das gesamte Los mit den ermittelten Korrekturwerten (Offset-Werten) belichtet. Diese erste Variante bietet die höchstmögliche Genauigkeit, hat aber auch einen entscheidenden Nachteil. Die Bearbeitung eines ganzen Loses dauert etwa 45 bis 60 Minuten, da für die einzelnen Prozeßschritte separate Einheiten in den Anlagen zur Verfügung stehen und somit mehrere Halbleiterscheiben gleichzeitig bearbeitet werden können. Die singuläre Bearbeitung und Vermessung einer einzelnen Halbleiterscheibe dauert jedoch ca. 15 bis 25 Minuten plus Meßzeit, so daß insgesamt der Durchsatz der Maschinen um mehr als 30 % absinkt.

Für die Massenproduktion hat sich daher eine zweite Variante, nämlich die statistische Überwachung der Meßwerte zur Ermittlung optimaler Einstell- oder Korrekturwerte durchgesetzt. Anfangs wurden einmal täglich die Meßergebnisse von einem Ingenieur ausgewertet und daraus die Korrekturwerte in Form von Belichtungsstärke- und xy-Positionierungs-Tabellen für die nächsten 24 Stunden festgelegt, wobei die Fokussierung zumeist auf einem konstanten Wert gehalten wird. Für diese Art der Auswertung hatten sich die sogenannten Western Electric Rules als zuverlässiges Instrument erwiesen. Diese Auswertung muß jedoch für jeden Photostepper, jedes Produkt und jede Belichtungsebene separat durchgeführt werden. Mit der steigenden Anzahl von Belichtungsebenen bei verschiedenen Produkten nimmt diese Optimierung Dimensionen an, welche nur noch durch eine Automation der Auswertung zu bewältigen ist.

In der Publikation "A practical automatic feedback system for poly photo CD control" von J.H. Chen und C.Y. Wang in SPIE, Vol. 2876, Seiten 225-231, wird eine Prozeßregelung für photolithographische Prozesse beschrieben, bei welcher unmittelbar vor Beginn der Prozessierung eines Loses aus den gemessenen Linienbreitefehlern und den dabei verwendeten Belichtungsstärken der vorangegangenen fünf (oder drei) Lose und den Soll-Linienbreiten mittels eines bekannten linearen Zusammenhangs zwischen der Linienbreite (eines Stegs oder eines Grabens) und der verwendeten Belichtungsstärke eine korrigierte Belichtungsstärke für das zu prozessierende Los berechnet und an dem Photostepper eingestellt wird. Derartige bekannte Regelsysteme können unter bestimmten Umständen instabil werden, wenn eine aufkommende Oszillation nicht nach kurzer Zeit verschwindet, sondern sich vielmehr aufschaukelt.

Dies kann beispielsweise passieren, wenn ein Los mit einem systematischen Meßfehler vermessen wird, somit die Meßergebnisse dieses Loses fälschlich signifikant von denen anderer Lose in eine bestimmte Richtung abweichen und/oder wenn ein schlechtes oder inkorrektes mathematisches Rechenmodell verwendet wird. Falls beispielsweise die für ein Los gemessene mittlere Linienbreite signifikant verfälscht ist, kann ihre Verwendung bei der Regelung zu einem falschen Wert für die korrigierte Belichtungsstärke führen, so daß sich der Fehler aufschaukelt und die Oszillation verstärkt wird.

Aus statistischer Sicht könnten derartige Störungen dadurch herausgemittelt werden, indem die Berechnung der Korrekturwerte aus den Meßdaten einer relativ großen Anzahl von zurückliegend bearbeiteten Losen durchgeführt wird. Dadurch steigt jedoch die Reaktionszeit des Regelsystems in nicht akzeptabler Weise an, so daß der Echtzeitcharakter des Regelsystems verloren geht.

Es ist dementsprechend Aufgabe der vorliegenden Erfindung, ein gattungsgemäßes Regelsystem für photolithographische Prozesse derart weiterzubilden, daß Instabilitäten der beschriebenen Art weitgehend vermieden werden können.

Ein erfindungsgemäßes Regelungsverfahren photolithographischer Prozesse an mit Photoresist beschichteten Halbleiterscheiben weist die folgenden Verfahrensschritte auf:

In einem ersten Verfahrensschritt a) wird zunächst eine photolithographische Prozessierung an einer vorgegebenen Anzahl (Los) von Halbleiterscheiben mit vorgegebenen Werten für die Belichtungsstärke und/oder die xy-Positionierung durchgeführt.

In einem zweiten Verfahrensschritt b) wird eine automatische oder manuelle Vermessung von Lagefehlern und/oder Linienbreitefehlern an den prozessierten Halbleiterscheiben des Loses durchgeführt.

In einem dritten Verfahrensschritt c) wird eine Berechnung von Korrekturwerten für die Belichtungsstärke und/oder die xy-Positionierung in bezug auf das prozessierte Los auf der Basis der gemessenen Lagefehler und/oder Linienbreitefehler, vorgegebener Soll-Werte für die Lage und/oder die Linienbreite und vorbestimmter Algorithmen für die Berechnung durchgeführt und die losbezogenen Korrekturwerte werden abgespeichert.

In einem vierten Verfahrensschritt d) werden optimierte Korrekturwerte für die Belichtungsstärke und/oder die xy-Positionierung für die Prozessierung eines gegebenenfalls nächsten Loses gleicher Ebene und Technologie auf der Basis solcher Korrekturwerte vorprozessierter Lose durchgeführt, die innerhalb eines vorbestimmten Wertebereichs liegen.

In einem fünften summarischen Verfahrensschritt e) werden die Verfahrensschritte a) bis e) mit dem nächsten Los erneut durchlaufen, wobei als vorgegebene Werte die optimierten Korrekturwerte verwendet werden.

Die im Verfahrensschritt a) zu Beginn des Verfahrens verwendeten vorgegebenen Werte können dadurch gewonnen werden, indem eine einzelne Vorläuferscheibe aufgrund voreingestellter Werte für die Belichtungsstärke und/oder die xy-Positionierung photolithographisch prozessiert wird und aus den an der Vorläuferscheibe gemessenen Werten der Lagefehler und/oder Linienbreitefehler, der vorgegebenen Soll-Werte für die Lage und/oder die Linienbreite und vorbestimmten Algorithmen für die Berechnung die vorgegebenen Werte ermittelt werden.

Die im Verfahrensschritt d) verwendeten Wertebereiche können dadurch festgelegt werden, daß aus einer Anzahl von Korrekturwerten von zurückliegend prozessierten Losen Standardabweichungen und Mittelwerte gebildet werden und das Zentrum der Wertebereiche durch die Mittelwerte und die Größe der Wertebereiche durch die mit einer Konstanten multiplizierten Standardabweichungen gebildet werden.

Die Wertebereiche werden somit maßgeblich durch die Vergangenheit oder "Geschichte" des photolithographischen Prozesses bestimmt.

Das erfindungsgemäße Regelungsverfahren verwendet somit die unmittelbar nach Prozessierung eines Loses aus der Vermessung berechneten losbezogenen Korrekturwerte als Regelgrößen. Eine sprunghafte Veränderung dieser Regelgrößen wird anfangs nicht erkannt, z.B. bei der Berechnung optimierter Korrekturwerte für die Prozessierung des nächsten Loses ignoriert, da ein sprunghaft veränderter Korrekturwert außerhalb des jeweiligen vorbestimmten Wertebereichs liegt. Erst wenn sich genügend abweichende Korrekturwerte im Speicher angesammelt haben, werden sie von der Regelung berücksichtigt, da die dann gestiegene Anzahl abweichender Korrekturwerte den Wertebereich entsprechend verschoben hat. Zufällige "Ausreißer" unter den Korrekturwerten, die beispielsweise durch nur zeitweilig auftretende systematische Meßfehler entstehen können, haben dagegen so gut wie keinen Einfluß auf den Regelungsprozeß, so daß es nicht zu Instabilitäten oder sich aufschaukelnden Oszillationen des Regelungsprozesses kommen kann.

Bei der Festlegung der Wertebereiche werden typischerweise die im Speicher abgespeicherten Korrekturwerte der letzten 15 bis 40 Lose gesucht, deren Einträge nicht älter als eine bestimmte Zeitspanne, beispielsweise 50000 Minuten sind. Aus den Korrekturwerten dieser Lose, also beispielsweise den Belichtungsstärkewerten dieser Lose, wird ein arithmetischer Mittelwert gebildet, der als Zentrum des Wertebereichs verwendet wird. Außerdem wird aus den Korrekturwerten eine Standardabweichung $\sigma$ gebildet und typischerwei-

se wird die Größe des Wertebereichs zu 2 σ bis 3 σ festgelegt.

Bevorzugterweise wird bereits im Verfahrensschritt c) beim Abspeichern der losbezogenen Korrekturwerte eine Überprüfung vorgenommen, ob die Korrekturwerte sich innerhalb der für sie vorgesehenen Wertebereiche befinden oder nicht, ob also der losbezogen ermittelte Korrekturwert für die Belichtungsstärke innerhalb des Belichtungsstärke-Wertebereichs liegt und ob der losbezogen ermittelte Korrekturwert für die xy-Positionierung innerhalb des xy-Positionierungs-Wertebereichs liegt. beim Abspeichern wird dann auf einem zugehörigen weiteren Speicherplatz eine entsprechende Kennung vorgenommen, beispielsweise OK für "innerhalb des Wertebereichs" und OL für "außerhalb des Wertebereichs". Im Verfahrensschritt d) können dann aufgrund dieser Kennung relativ einfach die für die Berechnung der optimierten Korrekturwerte zulässigen Korrekturwerte zurückliegend prozessierter Lose herausgefiltert werden.

Im Verfahrensschritt d) können die optimierten Korrekturwerte aus dem Mittelwert der letzten zurückliegenden zulässigen, d.h. beispielsweise mit OK gekennzeichneten Korrekturwerte gebildet werden. Typischerweise werden hierfür die letzten 5 bis 10 OK-markierten Datenbankeinträge verwendet.

Ein erfindungsgemäßes Regelsystem für photolithographische Prozesse an mit Photoresist beschichteten Halbleiterscheiben zur Durchführung des erfindungsgemäßen Regelprozesses weist die folgenden Einheiten oder Baugruppen auf:

- einen Photostepper enthaltend eine Lichtquelle mit variabler Belichtungsstärke, ein Maskenretikel und einen Auflagetisch für eine Halbleiterscheibe mit variabler xy-Positionierung,
- eine Meßstation für die automatische oder manuelle Messung von Lagefehlern und/oder Linienbreitefehlern der durch die Lithographie hergestellten Photoresiststrukturen,
- eine mit der Meßstation und dem Photostepper verbundene Rechner-/Speichereinheit zur

  - Berechnung von Korrekturwerten für die Belichtungsstärke und/oder die xy-Positionierung in bezug auf das prozessierte Los auf der Basis der gemessenen Lagefehler und/oder Linienbreitefehler, vorgegebener Soll-Werte für die Lage und/oder die Linienbreite und vorgegebener Algorithmen für die Berechnung, zum
  - Abspeichern der losbezogenen Korrekturwerte und zur
  - Berechnung optimierter Korrekturwerte für die Prozessierung eines gegebenenfalls nächsten Loses auf der Basis solcher Korrekturwerte vorprozessierter Lose, die innerhalb eines vorbestimmten Wertebereichs liegen.

Das erfindungsgemäße Regelsystem weist vorzugsweise ein steuerbares Stepperinterface als Verbindungsglied zwischen dem Photostepper und der Rechner-/Speichereinheit auf. Dieses Stepperinterface kann eine Eingabeeinheit und eine Anzeigeeinheit aufweisen und an der Eingabeeinheit können benutzerseitig Kenndaten betreffend die zu prozessierenden Lose oder Prozeßabläufe eingegeben werden und an der Anzeigeeinheit können Prozeß- oder Maschinenparameter oder dergleichen angezeigt werden.

Im folgenden wird das erfindungsgemäße Regelungsverfahren anhand der Figuren näher erläutert. Es zeigen:

Fig. 1    eine schematische Darstellung eines konventionellen Regelungsverfahrens für photolithographische Prozesse;

Fig. 2    eine Darstellung eines Flußdiagramms eines erfindungsgemäßen Regelungsverfahrens für photolithographische Prozesse.

Bei der folgenden Beschreibung des Standes der Technik und der Erfindung wird davon ausgegangen, daß an dem für die photolithographische Prozessierung verwendeten Photostepper im wesentlichen lediglich die Größen Belichtungsstärke E und die xy-Positionierung variabel sind, jedoch die Fokussierung, d. h. die Position des Maskenretikels auf der optischen Achse konstant bleibt.

Durch die Auswertung geeigneter Strukturen kann jedoch auch die Fokussierung gesteuert werden.

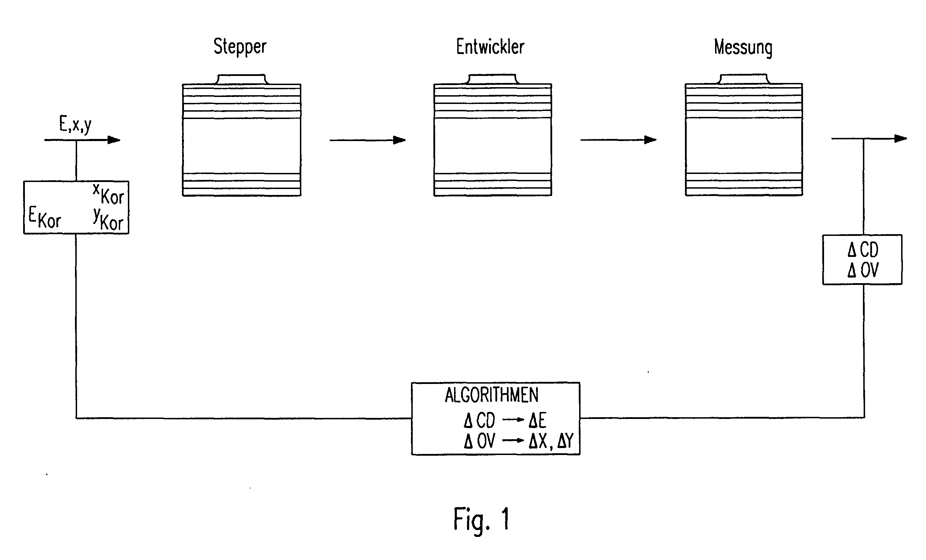

In der schematischen Darstellung der Fig. 1 sind drei Arbeitsstationen eines Regelsystems für eine photolithographische Prozessierung, nämlich ein Photostepper, eine Beladungs- und Entwicklungsstation und eine Meßstation, dargestellt. In jeder Arbeitsstation befindet sich ein Los Halbleiterscheiben und wird entsprechend den vorgegebenen Prozeßparametern verarbeitet.

Am Anfang jedes Prozeßablaufs müssen dem Photostepper zunächst vorgegebene Werte E und x, y geliefert werden, da er diese mangels Vorgeschichte noch nicht aus der Regelschleife beziehen kann. Es müssen daher in jedem Fall zuerst Erfahrungswerte in den Photostepper eingegeben werden. Anstatt mit diesen Erfahrungswerten gleich ein ganzes Los zu bearbeiten, kann jedoch zunächst eine sogenannte Vorläuferscheibe mit den Erfahrungswerten prozessiert werden. Die Vorläuferscheibe wird belackt und dann mit diesen vorgegebenen Werten im Photostepper prozessiert, in der Entwicklungsstation entwickelt und anschließend auf Lagefehler $\Delta$ OV und Linienbreitefehler $\Delta$ CD vermessen. Aus diesen werden mittels vorgegebener Algorithmen Korrekturwerte $E_{KOR}$ und $x_{KOR}$, $y_{KOR}$ berechnet. Mit diesen Korrekturwerten wird dann ein erstes Los von Halbleiterscheiben prozessiert. In dem Photostepper wird eine bestimmte Maskenstruktur bei der Belichtung auf die Photoresistschicht auf der Halbleiterscheibe abgebildet. Nachdem in der Entwicklungsstation, je nachdem, ob ein Positiv- oder ein Negativresist verwendet wurde, entweder die belichteten oder die unbelichteten Bereiche der Photoresistschicht entfernt wurden, werden in der Meßstation die erhaltenen Resiststrukturen mit einem Rasterelektronenmikroskop oder einem optischen Mikroskop auf Lagefehler und Linienbreitefehler vermessen. Zu diesem Zweck werden Teststrukturen verwendet, die aus Stegen, Gräben oder Löchern bestehen, deren Flanken stets geringfügig schräg gestellt sind. Bei Linienbreitenmessungen wird im Falle eines Steges als Teststruktur dessen Breite als gemessene Linienbreite angenommen, während im Falle eines Grabens als Teststruktur dessen untere Breite als gemessene Linienbreite angenommen wird. Aus den Lagefehlern und Linienbreitefehlern, den Soll-Werten für die xy-Position und die Linienbreite sowie den vorgegebenen Algorithmen für die Berechnung werden Korrekturwerte für die Belichtungsdosis E und die xy-Positionierung berechnet. Um eine statistische Mittelung zu erhalten, werden die Mittelwerte aus den Meßergebnissen einer bestimmten Anzahl zurückliegend prozessierter Lose bestimmt und als Grundlage für die Berechnung der Korrekturwerte verwendet. Eine geringe Anzahl von Losen, über deren Meßergebnisse gemittelt wird, bedeutet eine schnelle Reaktionszeit der Regelschleife, jedoch eine erhöhte Anfälligkeit für Instabilitäten aufgrund zufälliger "Ausreißer" und eine große Anzahl von Losen, über deren Meßergebnisse gemittelt wird, vermindert die Anfälligkeit für Instabilitäten, da über "Ausreißer" hinweggemittelt wird, macht die Reaktionszeit der Regelschleife aber relativ langsam.

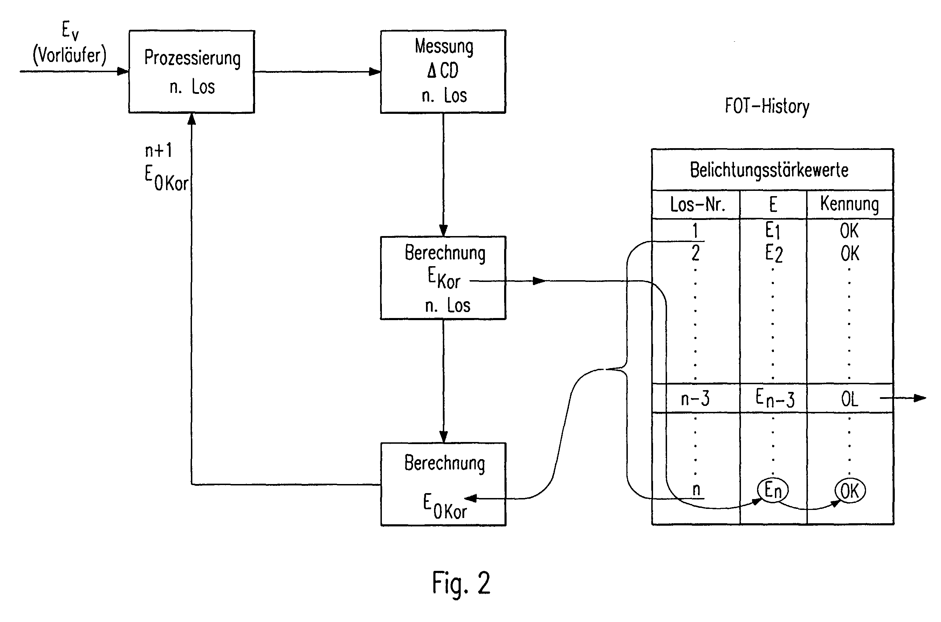

In Fig. 2 ist nun ein erfindungsgemäßes Regelungsverfahren nach Art eines vereinfachten Flußdiagramms schematisch dargestellt, wobei der Einfachheit halber nur eine Regelung der Belichtungsstärke über die gemessenen Linienbreiten dargestellt ist. Die Regelung kann aber ebenso parallel für eine Regelung der xy-Positionierung aus den gemessenen Overlay-Daten erfolgen.

Der Prozeßregelungsablauf wird für ein n.Los beschrieben. Wenn n = 1 ist, so muß der Wert für die Belichtungsstärke entweder als Erfahrungswert vorgegeben werden oder er wird - wie bereits beschrieben - als Belichtungsstärkewert $E_V$ aus der Prozessierung und Auswertung einer Vorläuferscheibe gewonnen. Wenn angenommen wird, daß die übrigen Parameter des Photosteppers entweder fest eingestellt sind oder eigenständig geregelt werden, so kann nunmehr das n. Los prozessiert werden. Nach Fertigstellung der Prozessierung liegt eine Anzahl Halbleiterscheiben mit Teststrukturen vor, deren Linienbreiten anschließend mit dem Rasterelektronenmikroskop vermessen werden. Aus den gemessenen Linienbreiten wird eine mittlere Linienbreite $CD_{mes}$ berechnet, aus der sich ein mittlerer Linienbreitefehler $\Delta CD = CD_{mes} - CD_{soll}$ für das n. Los ergibt.

Anschließend wird mittels der zwei folgenden Formeln ein Korrekturwert $E_{KOR}$ wie folgt ermittelt:

$$E_{KOR} = E_V - (CD_{mes} - CD_{soll})\, k$$

für Stege und

$$E_{KOR} = E_V + (CD_{mes} - CD_{soll})\, k$$

für Gräben und Löcher

Hierbei sind $E_{KOR}$ der Korrekturwert der Belichtungsstärke, $E_V$ der vorgegebene Wert der Belichtungsstärke, $CD_{mes}$ der Mittelwert der gemessenen Linienbreiten, $CD_{soll}$ der Soll-Wert der Linienbreite und k der Gradient des funktionalen Zusammenhangs zwischen der Linienbreite und der Belichtungsstärke.

An dieser Stelle sei erwähnt, daß für die Ermittlung der xy-Positionierungs-Korrekturwerte bei einer entsprechenden Regelung der Lagefehler eine wesentlich komplexere Auswertung vonnöten ist. Bei der Messung kann nur die Verschiebung einer Teststruktur in x- und y-Richtung ermittelt werden. Der Photostepper stellt jedoch für die Optimierung der Lagegenauigkeit ein 8- oder 10-Parameter-Modell zur Verfügung.

Im nächsten Schritt wird nun der berechnete Wert $E_{KOR}$ einem Tabellenspeicher ("FOT-History") zugeführt. In diesem Tabellenspeicher sind für sämtliche bereits prozessierten Lose die ermittelten Belichtungsstärkewerte $E_n$ zusammen mit der jeweiligen Los-Nr. und einer Kennung OK/OL abgespeichert. Zusätzlich kann auch der Zeitpunkt der jeweiligen Messung mitabgespeichert werden. Die Kennung OK oder OL wird aufgrund einer Überprüfung vergeben, ob der soeben ermittelte Korrekturwert $E_n$ innerhalb eines vorab ermittelten Wertebereichs liegt. Dieser Wertebereich wird durch die Korrekturwerte der früheren Lose, beispielsweise der zurückliegenden 15 bis 40 Lose, festgelegt. Dabei kann eine zeitliche Obergrenze bestehen, bis zu der zurückliegend prozessierte Lose mit ihren Korrekturwerten miteinbezogen werden sollen (beispielsweise 50000 Minuten). Aus diesen zurückliegend ermittelten Korrekturwerten wird ein Mittelwert gebildet, der das Zentrum des festzulegenden Wertebereichs bildet. Gleichzeitig wird eine Standardabweichung σ berechnet und die Größe des festzulegenden Wertebereichs wird durch Multiplikation von σ mit einer Konstanten, die beispielsweise zwischen 2 und 3 liegen kann, bestimmt. Danach kann sofort festgestellt werden, ob der kürzlich ermittelte Korrekturwert $E_n$ innerhalb des Wertebereichs liegt oder nicht. Im ersten Fall wird als Kennung OK vermerkt und im zweiten Fall wird als Kennung OL vermerkt.

Im nächsten Schritt wird ein optimierter Korrekturwert $E_{OKOR}$ dadurch berechnet, daß aus einer Anzahl der zuletzt ermittelten Korrekturwerte $E_n$, beispielsweise der letzten 10 bis 15 Korrekturwerte $E_n$, mit OK-

Kennung der arithmetische Mittelwert gebildet wird. Im vorliegenden Beispielsfall hat sich bei der Überprüfung im vorherigen Verfahrensschritt ergeben, daß der für die Los-Nr. n - 3 ermittelte Korrekturwert $E_{n-3}$ nicht innerhalb des Wertebereichs liegt und somit die Kennung OL erhalten hat. Dies hat zur Folge, daß im nunmehrigen Verfahrensschritt dieser Korrekturwert nicht in die Mittelwertbildung einbezogen wird und somit unbeachtet bleibt. In der Systematik des erfindungsgemäßen Regelungsverfahrens wird dieser Korrekturwert als "Ausreißer" bewertet und für den Regelungsprozeß nicht in Betracht gezogen.

Es ist auch möglich, zurückliegend ermittelte Korrekturwerte bestimmter Lose in unterschiedlicher Weise zu gewichten, z.B. das letzte gemessene Los mit doppelter Gewichtung zu belegen als die übrigen gemessenen Lose.

Anders würde es sich verhalten, wenn die Abweichung des Korrekturwertes $E_{n-3}$ kein zufälliger "Ausreißer" gewesen wäre, sondern wenn er eine beginnende Drift von Prozeßparametern des Photosteppers oder dergleichen als Ursache gehabt hätte. Dann wären auch die nachfolgenden Korrekturwerte mit der Kennung OL versehen worden und wären somit zunächst ebenfalls unbeachtet geblieben. Da jedoch auch die mit OL gekennzeichneten Korrekturwerte selbst für die Bestimmung der Streuung herangezogen werden, verschiebt sich nach einer gewissen Häufung von mit OL gekennzeichneten Korrekturwerten der Wertebereich in Richtung dieser Korrekturwerte, so daß diese Korrekturwerte nach einer gewissen Zeit innerhalb des verschobenen Wertebereichs zu liegen kommen. Dann führt die Regelung auch zu einer Korrektur der optimierten Korrekturwerte $E_{OKOR}$.

## Patentansprüche

1. Regelsystem für photolithographische Prozesse an mit Photoresist beschichteten Halbleiterscheiben, mit

   - einem Photostepper enthaltend eine Lichtquelle mit variabler Belichtungsstärke, ein Maskenretikel, und einen Auflagetisch für eine Halbleiterscheibe mit variabler xy-Positionierung,
   - eine Meßstation für die automatische oder manuelle Vermessung von Lagefehlern und/oder Linienbreitefehlern der durch die Photolithographie hergestellten Photoresiststrukturen,
   - eine mit der Meßstation und dem Photostepper verbundene Rechner-/Speichereinheit zur

     - Berechnung von Korrekturwerten ($E_{KOR}$; $xy_{KOR}$) für die Belichtungsstärke und/oder die xy-Position in bezug auf das prozessierte Los auf der Basis der gemessenen Lagefehler ($\Delta OV$) und/oder Linienbreite-

fehler ($\Delta CD$), vorgegebener Soll-Werte für die Lage ($OV_{soll}$) und/oder die Linienbreite ($CD_{soll}$) und vorgegebener Algorithmen für die Berechnung, zum

   - Abspeichern der losbezogenen Korrekturwerte und zur
   - Berechnung optimierter Korrekturwerte ($E_{OKOR}$; $xy_{OKOR}$) für die Prozessierung eines gegebenenfalls nächsten Loses auf der Basis solcher Korrekturwerte vorprozessierter Lose, die innerhalb eines vorbestimmten Wertebereichs liegen.

2. Regelsystem nach Anspruch 1,
   **gekennzeichnet durch,**

   - ein steuerbares Stepperinterface als Verbindungsglied zwischen dem Photostepper und der Rechner-/Speichereinheit.

3. Regelsystem nach Anspruch 2,
   **dadurch gekennzeichnet, daß**

   - das Stepperinterface eine Eingabeeinheit und eine Anzeigeeinheit aufweist, und
   - an der Eingabeeinheit Kenndaten betreffend die zu prozessierenden Lose von Halbleiterscheiben eingebbar sind.

4. Verfahren zur Regelung photolithographischer Prozesse, mit den Verfahrensschritten,

   a) photolithographische Prozessierung einer vorgegebenen Anzahl (Los) von Halbleiterscheiben mit vorgegebenen Werten für die Belichtungsstärke ($E_v$) und/oder die xy-Positionierung ($xy_v$),
   b) automatische oder manuelle Vermessung von Lagefehlern ($\Delta OV$) und/oder Linienbreitefehlern ($\Delta CD$) an den prozessierten Halbleiterscheiben,
   c) Berechnung von Korrekturwerten für die Belichtungsstärke ($E_{KOR}$) und/oder die xy-Position ($xy_{KOR}$) in bezug auf das prozessierte Los auf der Basis der gemessenen Lagefehler ($\Delta OV$) und/oder Linienbreitefehler ($\Delta CD$), vorgegebener Soll-Werte für die Lage ($OV_{soll}$)und/oder die Linienbreite ($CD_{soll}$) und vorbestimmter Algorithmen für die Berechnung, und Abspeichern der losbezogenen Korrekturwerte ($E_{KOR}$, $xy_{KOR}$),
   d) Berechnung optimierter Korrekturwerte ($E_{OKOR}$, $xy_{OKOR}$) für die Prozessierung eines gegebenenfalls nächsten Loses auf der Basis solcher Korrekturwerte zurückliegend prozessierter Lose, die innerhalb eines vorbestimmten Wertebereichs liegen,
   e) erneutes Durchlaufen der Verfahrensschritte a) bis e) mit dem nächsten Los, wobei als vorgegebene Werte die optimierten Korrekturwerte verwendet werden.

5. Verfahren nach Anspruch 4,
   **dadurch gekennzeichnet, daß**

   - im Verfahrensschritt c) die Wertebereiche für die bei der Berechnung zu verwendenden Meßwerte dadurch festgelegt werden, daß
   - aus einer Anzahl von Meßwerten von zurückliegend prozessierten Losen Standardabweichungen und Mittelwerte gebildet werden, und
   - das Zentrum der Wertebereiche durch die Mittelwerte und die Größe der Wertebereiche durch die mit einer Konstanten multiplizierten Standardabweichungen gebildet werden.

Fig. 1

Fig. 2